**Europäisches Patentamt**

**European Patent Office**

**Office européen des brevets**

(19)

(11) Veröffentlichungsnummer: **0 075 102**
**B1**

(12) # EUROPÄISCHE PATENTSCHRIFT

(45) Veröffentlichungstag der Patentschrift:
**11.05.88**

(21) Anmeldenummer: **82107296.4**

(22) Anmeldetag: **11.08.82**

(51) Int. Cl.⁴: **H 01 L 29/743, H 01 L 29/04, H 01 L 29/06, H 01 L 21/306**

(54) **Thyristor mit einem Mehrschichten-Halbleiterkörper mit pnpn-Schichtfolge und Verfahren zu seiner Herstellung.**

(30) Priorität: **22.09.81 DE 3137695**

(43) Veröffentlichungstag der Anmeldung:
**30.03.83 Patentblatt 83/13**

(45) Bekanntmachung des Hinweises auf die Patenterteilung:
**11.05.88 Patentblatt 88/19**

(84) Benannte Vertragsstaaten:
**CH FR GB IT LI NL SE**

(56) Entgegenhaltungen:
**DE - A - 1 427 770**
**DE - A - 1 564 146**
**DE - A - 2 540 430**
**US - A - 3 765 969**
**US - A - 4 110 780**

(73) Patentinhaber: **Siemens Aktiengesellschaft Berlin und München, Wittelsbacherplatz 2, D-8000 München 2 (DE)**

(72) Erfinder: **Herberg, Helmut, Dr., Kobellstrasse 12, D-8000 München 2 (DE)**

EP 0 075 102 B1

## Beschreibung

Die Erfindung bezieht sich auf einen Thyristor mit einem Mehrschichten-Halbleiterkörper mit pnpn-Schichtfolge nach dem Oberbegritf des Anspruchs 1 sowie auf Verfahren zu seiner Herstellung.

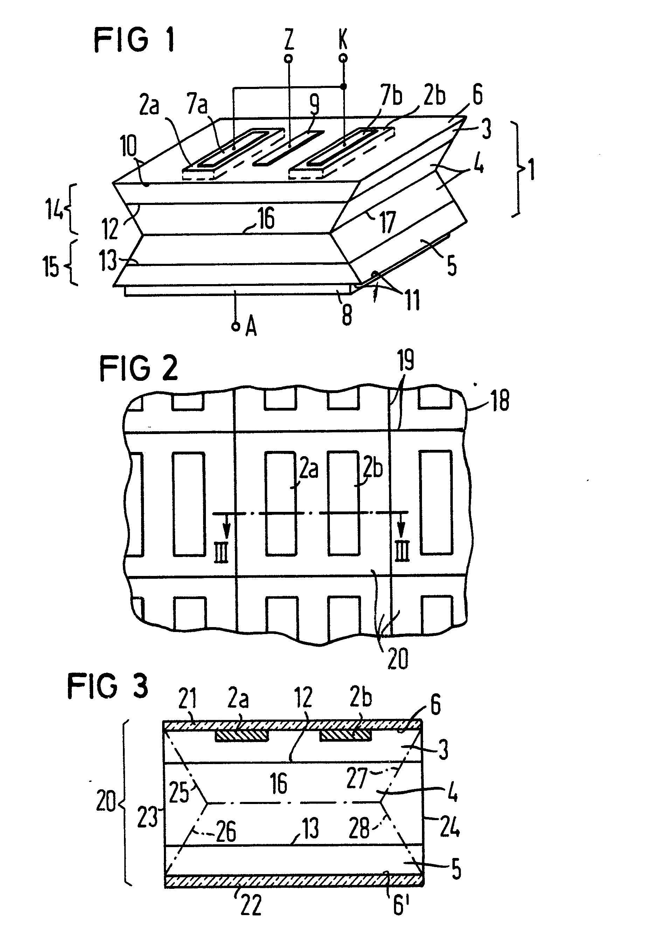

Thyristoren dieser Art sind z. aus dem Buch «Thyristor Physics» von A. Blicher, Springer-Verlag, New York 1976, Seiten 198 bis 200, insbesondere Fig. 14.1, bekannt. In «Semiconductor Power Devices» von S. K. Ghandhi, Verlag John Wiley & Sons, London 1977, Seite 81, insb. Fig. 2.34b sind Thyristoren der eingangs genannten Art beschrieben, deren Rand doppelt abgeschrägt ist, so dass er sich von der oberen und unteren Grenzfläche ausgehend in Richtung auf eine zwischen diesen Grenzflächen liegende Ebene jeweils verjüngt. In dieser Ebene befindet sich die minimale Querschnittsfläche des Thyristors, wenn lediglich Querschnitte parallel zu den pn-Übergängen zugrundegelegt werden. Man spricht hierbei auch von Thyristoren, deren Rand zwei positive Winkel mit der oberen und unteren Grenzfläche einschliesst bzw. von Thyristoren mit einem Schwalbenschwanzprofil.

Der doppelt abgeschrägte Rand eines solchen Thyristors wird durch die Einwirkung eines zu den Grenzflächen schräg geführten Sandstrahls erzeugt. Anschliessend muss jedoch der Rand einem Ätzvorgang unterzogen werden, um die durch den genannten mechanischen Bearbeitungsvorgang entstandenen Kurzschlüsse, die die pn-Übergänge überbrücken, zu beseitigen.

Es ist auch aus der US-A-3 765 969 bekannt, in einkristallinen Silizium-Halbleiterkörpern {111}-orientierte Flächen durch Ätzen unter Ausnutzung des anisotropen Ätzverhaltens von Silizium mit bestimmten Ätzmitteln zu erzeugen. Dabei werden in der US-A-3 765 969 Möglichkeiten des Einbringens von V-förmigen Gräben in die {100}-Oberflächen von Silizium-Halbleiterscheiben beschrieben. Die Anwendbarkeit dieses Verfahrens auch bei {110}-orientierten Flächen ist nicht erwähnt.

Ferner ist aus der DE-A-1 564 146 ein pnpn-Thyristor bekannt, dessen Berandungsprofil im Querschnitt schwalbenschwanzförmig ist. Dabei handelt es sich jedoch um einen scheibenförmigen, axialsymmetrischen Thyristor, wobei über die Orientierung der zu den pn-Übergängen parallelen Grenzflächen keine Aussage gemacht ist. Auch in diesem Fall wird das Schwalbenschwanzprofil mittels «Sandstrahlen» erzeugt.

Der Erfindung liegt die Aufgabe zugrunde, einen Thyristor der eingangs genannten Art mit einem Schwalbenschwanzprofil anzugeben, der in einfacher Weise, d.h. ohne den Arbeitsgang des Sandstrahlens, herstellbar ist. Das wird erfindungsgemäss durch eine Ausbildung des Thyristors gemäss dem kennzeichnenden Teil des Patentanspruchs 1 erreicht.

Der mit der Erfindung erzielbare Vorteil besteht insbesondere darin, dass der doppelt abgeschrägte Rand des Thyristor-Halbleiterkörpers lediglich durch einen Ätzvorgang, d.h. ohne ein vorheriges Sandstrahlen, hergestellt werden kann und dass die Herstellung der Randgeometrie in diesem Ätzvorgang so erfolgt, dass keine randseitigen Kurzschlüsse auftreten.

Die Ansprüche 2 bis 8 sind auf bevorzugte Verfahren zur Herstellung eines Thyristors nach der Erfindung gerichtet.

Die Erfindung wird nachfolgend anhand der Zeichnung näher erläutert. Dabei zeigt:

Fig. 1 einen nach der Erfindung ausgebildeten Thyristor,

Fig. 2 eine Draufsicht auf einen scheibenförmigen Mehrschichten-Halbleiterkörper, aus dem mehrere nach der Erfindung ausgebildete Thyristoren hergestellt werden und

Fig. 3 eine im Verlauf des Herstellungsverfahrens eines Thyristors nach Fig. 1 erreichte Zwischenstufe.

In Fig. 1 ist ein nach der Erfindung ausgebildeter Thyristor dargestellt. Er weist einen Körper 1 aus monokristallinem Halbleitermaterial, z.B. Silizium, auf, der n-leitende Schichten 2a, 2b und 4 und p-leitende Schichten 3 und 5 enthält. Die aus zwei Teilen 2a und 2b bestehende Schicht 2a, 2b wird auch als n-Emitter bezeichnet, die Schicht 3 als p-Basis, die Schicht 4 als n-Basis und die Schicht 5 als p-Emitter. Die Teile 2a und 2b des n-Emitters sind an der Grenzfläche 6 des Halbleiterkörpers 1 mit zwei streifenförmigen Belegungen 7a, 7b aus elektrisch leitendem Material, z.B. Aluminium, versehen, die zusammen die Kathode des Thyristors bilden. Sie sind mit einem Anschluss K verbunden. Der p-Emitter 5 wird in der gegenüberliegenden Grenzfläche des Halbleiterkörpers von einer Anode 8 aus elektrisch leitendem Material, z.B. Aluminium, kontaktiert. Die Anode 8 ist mit einem Anschluss A verbunden. Eine Zündelektrode 9, die mit dem Anschluss Z eines Zündstromkreises beschaltet ist, kontaktiert die p-Basis 3.

Die Grenzfläche 6 ist eine {100}-orientierte Halbleiterfläche. Sie ist rechteckförmig ausgebildet und weist laterale Begrenzungen 10 auf, die parallel zu ⟨110⟩-Richtungen verlaufen. Die der Grenzfläche 6 gegenüberliegende Fläche ist ebenfalls {100}-orientiert, rechteckförmig ausgebildet und besitzt laterale Begrenzungen 11, die parallel zu ⟨110⟩-Richtungen verlaufen. 12 bezeichnet den pn-Übergang zwischen den Schichten 3 und 4, während der pn-Übergang zwischen den Schichten 4 und 5 mit dem Bezugszeichen 13 versehen ist. Von den beiden einander entsprechenden, sichtbaren, lateralen Begrenzungen 10 und 11, die parallel zur Bildebene verlaufen, geht ein Paar von Seitenflächen 14, 15 des Halbleiterkörpers 1 aus, die sich in einer parallel zu der Grenzfläche 6 verlaufenden Geraden 16 schneiden. Analog hierzu gehen von den beiden rechten, in Fig. 1 schräg nach hinten verlaufenden lateralen Begrenzungen 10 und 11 zwei Seitenflächen aus, die sich in einer Geraden 17 treffen. Auch die übrigen lateralen Begrenzungen 10 und 11 sind in entsprechender Weise jeweils durch Paare von Seitenflächen miteinander verbunden, wobei sich jeweils die beiden zu einem solchen Paar gehörenden Seitenflächen in einer Ebene schneiden, der auch die Geraden 16 und 17 angehören. In dieser Ebene weist der Halbleiterkörper 1 eine minimale Querschnittsfläche auf, wenn man lediglich Querschnitte parallel zu den pn-Übergängen 12, 13 betrachtet. Sämtliche der genannten Seitenflächen, z.B. 14 und 15, sind jeweils {111}-orientierte Halbleiterflächen.

Die Funktionsweise des Thyristors 1 entspricht der von herkömmlichen Thyristoren und ist beispielsweise in dem Buch von S.M. Sze «Physics of Semiconductor Devices», Verlag John Wiley and Sons, New York, 1969, Seiten 320 bis 340, beschrieben.

In Fig. 2 ist ein Teil eines monokristallinen, scheibenförmigen Mehrschichten-Halbleiterkörpers 18 in Draufsicht dargestellt, aus dem mehrere Thyristoren nach Fig. 1 hergestellt werden. Seine sichtbare obere Grenzfläche ist dabei {100}-orientiert, ebenso wie die ihr gegenüberliegende untere Grenzfläche. Der Halbleiterkörper 18 ist an den vorstehend genannten Grenzflächen mit einer in Fig. 2 nicht dargestellten Maskierungsschicht bedeckt, die z.B. aus Siliziumnitrid ($Si_3N_4$) oder $SiO_2$ besteht.

Wird der Halbleiterkörper 18 entlang von in Fig. 2 eingezeichneten, mit den $\langle 110 \rangle$-Richtungen innerhalb der sichtbaren Grenzfläche zusammenfallenden Trennungslinien 19 aufgeteilt, so entstehen mehrere quaderförmige Halbleiterstücke 20, von denen eines in Fig. 3 dargestellt ist. Fig. 3 zeigt dabei einen Querschnitt entlang der Linie III–III von Fig. 2. Die laterale Begrenzung der Halbleiterstücke 20, von denen jedes eine Zwischenstufe in der Herstellung eines Thyristors nach Fig. 1 darstellt, ist entweder rechteckförmig oder quadratisch.

Wie aus den Figuren 2 und 3 im einzelnen hervorgeht, weist jedes der untereinander gleich ausgebildeten Halbleiterstücke 20 eine Schichtfolge 2a, 2b, 3, 4 und 5 entsprechend Fig. 1 auf. Dabei sind die Teile 2a und 2b der n-leitenden Schicht 2a, 2b streifenförmig ausgebildet und derart in die p-leitende Schicht 3 eingefügt, dass sie sich bis zur oberen Grenzfläche 6 des Halbleiterstücks 20 erstrecken. Die Längserstreckung der streifenförmigen Teile 2a und 2b ist dabei kleiner als die Abmessung des Halbleiterstücks 20 in derselben Richtung. Die pn-Übergänge 12 und 13 zwischen den Schichten 3, 4 und 5, die im wesentlichen parallel zu der Grenzfläche 6 und zu der gegenüberliegenden Grenzfläche 6' liegen, sind ebenfalls entsprechend Fig. 1 bezeichnet. Weiterhin sind in Fig. 3 die Maskierungsschichten, mit denen die obere und untere Grenzfläche des scheibenförmigen Halbleiterkörpers 18 bedeckt sind, mit den Bezugszeichen 21 und 22 versehen.

Wird nun eines der gemäss Fig. 3 ausgebildeten Halbleiterstücke 20 einem anisotropen Ätzvorgang mit einem Medium unterzogen, das z.B. aus einer wässrigen Lösung von KOH besteht, die auf etwa 80 °C erwärmt ist, so wird in jede der von den Maskierungsschichten 21 und 22 nicht bedeckten Trennflächen, z.B. 23 und 24, jeweils ein V-förmiger Graben eingeätzt, dessen Wandungsteile in Fig. 3 gestrichelt angedeutet und mit 25 bis 28 bezeichnet sind. Diese Wandungsteile stellen jeweils {111}-orientierte Halbleiterflächen dar und entsprechen z.B. den Flächen 14 und 15 in Fig. 1. Die Wandungsteile des V-förmigen Grabens, der in die in Fig. 3 sichtbare, zur Bildebene parallele Trennfläche eingeätzt wird, schneiden sich entlang einer gestrichelt angedeuteten Geraden 16, die der Geraden 16 in Fig. 1 entspricht.

Nach dem Ätzvorgang werden die Maskierungsschichten 21 und 22 von den Grenzflächen 6 und 6' entfernt und die Teile 2a und 2b mit Belegungen 7a und 7b aus einem metallisch leitenden Material versehen. Nach dem Aufbringen der Anode 8 auf der Schicht 5 und der Zündelektrode 9 auf der Schicht 3 sowie der Anschlüsse A, K und Z ergibt sich schliesslich ein Thyristor nach Fig. 1.

Das Heraustrennen der Halbleiterstücke 20 aus dem scheibenförmigen Mehrschichten-Halbleiterkörper 18 erfolgt zweckmässigerweise durch Sägen oder durch ein Abtasten der Oberfläche des genannten Halbleiterkörpers mit dem Strahl einer Laseranordnung, z.B. eines $CO_2$- oder NdYAG-Lasers, der die Trennungslinien 19 entlanggeführt wird. Der Öffnungswinkel der nach vorstehendem hergestellten Thyristoren, gemessen zwischen den Seitenflächen, z.B. 14 und 15, und den Grenzflächen 6 bzw. 6' entspricht 109,5°. Die Ätzzeit bei der Herstellung der V-förmigen Gräben 25 bis 28 kann innerhalb eines grossen Toleranzbereiches schwanken, da die Wandungsteile 25 bis 28 jeweils {111}-orientierte Halbleiterflächen sind, bei denen die Ätzrate sehr klein ist. Dadurch ist die Reproduzierbarkeit der in Fig. 1 dargestellten Form des Thyristor-Halbleiterkörpers 1 sehr hoch.

**Patentansprüche**

1. Thyristor mit einem Mehrschichten-Halbleiterkörper mit pnpn-Schichtfolge, der zwei Grenzflächen besitzt, die zu den pn-Übergängen zwischen den einzelnen Schichten im wesentlichen parallel liegen, dadurch gekennzeichnet, dass die Grenzflächen (6, 6') eine {100}-Orientierung aufweisen, rechteckförmig ausgebildet sind und laterale Begrenzungen (10, 11) haben, die parallel zu den $\langle 110 \rangle$-Richtungen verlaufen, und dass mehrere {111}-orientierte Paare von Seitenflächen (14, 15) vorgesehen sind, die jeweils von einander entsprechenden Begrenzungen (10, 11) beider Grenzflächen ausgehen und sich in einer zwischen den Grenzflächen befindlichen, zu diesen parallelen Ebene (16, 17) treffen, in der der Halbleiterkörper eine parallel zu diesen Grenzflächen liegende, rechteckförmige, minimale Querschnittsfläche besitzt.

2. Verfahren zum Herstellen eines Thyristors nach Anspruch 1, dadurch gekennzeichnet, dass ein monokristalliner scheibenförmiger Mehrschichten-Halbleiterkörper (18) mit einer pnpn-Schichtfolge und mit zwei einander gegenüberliegenden, {100}-orientierten und zu den pn-Übergängen (12, 13) zwischen den einzelnen Schichten im wesentlichen parallelen Grenzflächen (6, 6') verwendet wird, die jeweils mit einer Maskierungsschicht (21, 22) bedeckt werden, dass der Mehrschichten-Halbleiterkörper des Thyristors entlang mehrerer Trennflächen (23, 24) aus dem scheibenförmigen Mehrschichten-Halbleiterkörper (18) herausgetrennt wird, wobei jede der Trennflächen (23, 24) durch eine Trennungslinie (19) verläuft, die in einer der {100}-orientierten Grenzflächen (6, 6') des scheibenförmigen Mehrschichten-Halbleiterkörpers (18) liegt und parallel zu einer ⟨110⟩-Richtung orientiert ist, dass der Mehrschichten-Halbleiterkörper des Thyristors im Bereich der Trennflächen (23, 24) einem Ätzvorgang mit einem anisotrop wirkenden Ätzmittel unterzogen wird, durch den V-förmige Gräben eingeätzt werden, deren Wandungsteile (25 bis 28) aus {111}-orientierten Seitenflächen bestehen, und dass die Maskierungsschichten (21, 22) entfernt werden.

3. Verfahren nach Anspruch 2, dadurch gekennzeichnet, dass der scheibenförmige Mehrschichten-Halbleiterkörper (18) aus Silizium besteht.

4. Verfahren nach Anspruch 2 oder 3, dadurch gekennzeichnet, dass die Maskierungsschichten (21, 22) aus $Si_3N_4$ bestehen.

5. Verfahren nach Anspruch 2 oder 3, dadurch gekennzeichnet, dass die Maskierungsschichten (21, 22) aus $SiO_2$ bestehen.

6. Verfahren nach Anspruch 2, dadurch gekennzeichnet, dass als Ätzmittel eine Lösung aus Kaliumhydroxid verwendet wird.

7. Verfahren nach Anspruch 2, dadurch gekennzeichnet, dass das Heraustrennen des Thyristor-Halbleiterkörpers aus dem scheibenförmigen Mehrschichten-Halbleiterkörper (18) durch Sägen erfolgt.

8. Verfahren nach Anspruch 2, dadurch gekennzeichnet, dass das Heraustrennen des Thyristor-Halbleiterkörpers aus dem scheibenförmigen Mehrschichten-Halbleiterkörper (18) durch Bestrahlung mit einem Laserstrahl erfolgt.

**Claims**

1. A thyristor comprising a multi-layer semiconductor body with a pnpn-layer sequence which has two boundary surfaces which basically extend parallel to the pn-junctions between the individual layers, characterised in that the boundary surfaces (6, 6') have a {100}-orientation, are of rectangular formation, and are delimited by lateral boundaries (10, 11) which extend parallel to the ⟨110⟩-directions, and that a plurality of {111}-orientated pairs of side surfaces (14, 15) are provided which each start from mutually corresponding boundaries (10, 11) of the two boundary surfaces and meet in a plane (16, 17) which is located between the boundary surfaces and extends parallel thereto and in which the semiconductor body has a rectangular, minimal cross-sectional area extending parallel to these boundary surfaces.

2. A process for the production of a thyristor as claimed in Claim 1, characterised in that a monocrystalline, plate-shaped multi-layer semiconductor body (18) is used which has a pnpn-layer sequence and two boundary surfaces (6, 6') which are arranged opposite one another, are {100}-orientated, and basically extend parallel to the pn-junctions (12, 13) between the individual layers, and which are each covered by a masking layer (21, 22); that the multi-layer semiconductor body of the thyristor is separated from the plate-shaped multi-layer semiconductor body (18) along a plurality of separating surfaces (23, 24), where each of the separating surfaces (23, 24) extends through a separating line (19) which is located in one of the {100}-orientated boundary surfaces (6, 6') of the plate-shaped multi-layer semiconductor body (18) and is orientated parallel to a ⟨110⟩-direction; that the multi-layer semiconductor body of the thyristor ist subjected in the region of the boundary surfaces (23, 24), to an etching process using an anisotropically-acting etching agent, by means of which V-shaped trenches are etched in, the wall portions (25 to 28) of which constist of {111}-orientated side surfaces; and that the masking layers (21, 22) are removed.

3. A process as claimed in Claim 2, characterised in that the plate-shaped multi-layer semiconductor body (18) consists of silicon.

4. A process as claimed in Claim 2 or 3, characterised in that the masking layers (21, 22) consist of $Si_3N_4$.

5. A process as claimed in Claim 2 or 3, characterised in that the masking layers (21, 22) consist of $SiO_2$.

6. A process as claimed in Claim 2, characterised in that a solution of potassium hydroxide is used as etching agent.

7. A process as claimed in Claim 2, characterised in that the separation of the thyristor semiconductor body from the plate-shaped multi-layer semiconductor body (18) is effected by sawing.

8. A method as claimed in Claim 2, characterised in that the separation of the thyristor semiconductor body from the plate-shaped multi-layer semiconductor body (18) is effected by irradiation using a laser beam.

**Revendications**

1. Thyristor comportant un corps semiconducteur à couches multiples, disposé selon la suite pnpn et qui comporte deux surfaces limites, et sont sensiblement parallèles aux jonctions pn présentes entre les différentes couches, caractérisé en ce que les surfaces limites (6, 6') possèdent une orientation {100}, sont réalisées avec une forme rectangulaire et possèdent des limites latérales (10, 11) qui sont parallèles aux directions ⟨110⟩, et qu'il est prévu plusieurs couples de surfaces latérales (14, 15), qui possèdent l'orientation {111}, s'étendent respectivement à partir de limites (10, 11), qui se correspondent réciproquement, de deux surfaces limites et se rencontrent dans un plan (16, 17) situé entre les surfaces limites et parallèles à ces dernières et dans lequel le corps semiconducteur possède une surface en coupe transversale rectangulaire minimale, parallèle à ces surfaces limites.

2. Procédé pour fabriquer un thyristor suivant la revendication 1, caractérisé par le fait qu'on utilise un corps semiconducteur monocristallin en forme de disque (18) à couches multiples se succédant selon la suite pnpn et possédant deux surfaces limites (6, 6') opposées, qui possèdent l'orientation {100}, sont sensiblement parallèles aux jonctions pn (12, 13) présentes entre les différentes couches et que l'on recouvre chacune d'une couche de masquage (21, 22), qu'on divise le corps semiconducteur à couches multiples du thyristor le long de plusieurs surfaces de séparation (23, 24), à partir du corps semiconducteur à couches multiples (18) en forme de disque, chacune des surfaces de séparation (23, 24) passant par une ligne de séparation (19) qui est située dans l'une des surfaces limites (6, 6'), possédant l'orientation {100}, du corps semiconducteur à couches multiples (18) en forme de disque, et est parallèle à une direction ⟨110⟩, qu'on soumet le corps semiconducteur à couches multiples du thyristor, dans la zone des surfaces de séparation (23, 24), à un processus de corrosion avec un agent corrosif à effet anisotrope, qui forme par corrosion des sillons en V dont les éléments de paroi (25 à 28) sont constitués par des surfaces latérales possédant l'orientation {111}, et qu'on élimine les couches de masquage (21, 22).

3. Procédé suivant la revendication 2, caractérisé par le fait que le corps semiconducteur à couches multiples (18) en forme de disque est constitué par du silicium.

4. Procédé suivant la revendication 2 ou 3, caractérisé par le fait que les couches de masquage (21, 22) sont constituées par du $Si_3O_4$.

5. Procédé suivant la revendication 2 ou 3, caractérisé par le fait que les couches de masquage (21, 22) sont constituées par du $SiO_2$.

6. Procédé suivant la revendication 2, caractérisé par le fait qu'on utilise comme agent corrosif une solution d'hydroxyde de potassium.

7. Procédé suivant la revendication 2, caractérisé par le fait que la séparation du corps semiconducteur du thyristor à partir du corps semiconducteur à couches multiples (18) en forme de disque s'effectue par sciage.

8. Procédé selon la revendication 2, caractérisé en ce que la séparation du corps semiconducteur du thyristor à partir du corps semiconducteur à couches multiples (18) en forme de disque s'effectue par irradiation avec un faisceau laser.

FIG 1

FIG 2

FIG 3